(19) Europäisches Patentamt
European Patent Office
Office européen des brevets

(11) **EP 4 465 070 A1**

(12) **EUROPEAN PATENT APPLICATION**

(43) Date of publication:
**20.11.2024 Bulletin 2024/47**

(21) Application number: **23173689.3**

(22) Date of filing: **16.05.2023**

(51) International Patent Classification (IPC):
**G01R 33/483** (2006.01)   **G01R 33/561** (2006.01)

(52) Cooperative Patent Classification (CPC):
**G01R 33/5612; G01R 33/4835**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Siemens Healthineers AG**
  **91301 Forchheim (DE)**
• **Cambridge Enterprise Limited**
  **Cambridge CB2 1TN (GB)**
• **The University Court of the University of Glasgow**
  **Glasgow G12 8QQ (GB)**

(72) Inventors:
• **Ding Yuan, Belinda**
  **Glasgow, G132EX (GB)**

• **Dragonu, Iulius**
  **Harrow, HA2 0JB (GB)**
• **Neji, Radhouene**
  **London, N65XP (GB)**
• **Porter, David Andrew**
  **93055 Regensburg (DE)**
• **Rodgers, Christopher**
  **Linton, CB21 4HT (GB)**
• **Williams, Sydney**
  **Glasgow, G3 8LZ (GB)**
• **Zhang, Minghao**
  **Cambridge, CB2 1RD (GB)**

(74) Representative: **Siemens Healthineers Patent Attorneys**
**Postfach 22 16 34**
**80506 München (DE)**

(54) **OPTIMIZED RF-WAVEFORMS FOR SIMULTANEOUS MULTI-SLICE PARALLEL TRANSMISSION MAGNETIC RESONANCE IMAGING**

(57) For determining channel-specific RF-waveforms for excitation RF-pulses for SMS-pTx-MRI, for each combination of a slice and a transmission channel, a combination-specific RF-waveform, which comprises a phase offset, the phase offset comprising a variable slice-specific phase, which depends on the respective slice and is the same for all transmission channels, is determined. For each transmission channel, a variable channel-specific RF-waveform is determined by summing up all of the combination-specific RF-waveforms, which correspond to the respective transmission channel. For each slice, a final slice-specific phase is determined by minimizing a cost function using the variable slice-specific phases as optimization variables, wherein the cost function corresponds to a maximum of the respective absolute values of the variable channel-specific RF-waveforms within a predefined time interval. For each transmission channel, a final channel-specific RF-waveform is determined by replacing the variable slice-specific phases in the respective variable channel-specific RF-waveform by the final slice-specific phases.

FIG 1

**Description**

The present invention is directed to a computer-implemented method for determining channel-specific RF-waveforms for excitation RF-pulses for simultaneous multi-slice parallel transmission magnetic resonance imaging, SMS-pTx-MRI. The invention is further directed to a method for SMS-pTx-MRI, wherein such as a computer-implemented method is carried out, to a data processing apparatus for carrying out such computer-implemented method, to an MRI-system comprising such a data processing apparatus and to corresponding computer program products.

In magnetic resonance imaging, MR-imaging, simultaneous multi-slice, SMS, imaging, also denoted as multi-band, MB, imaging allows several slices to be imaged simultaneously, which significantly reduces the required scan time.

Furthermore, parallel radio frequency, RF, transmission, also denoted as pTx, uses the transmission of excitation RF-pulses in two or more transmission channels, wherein each transmission channel corresponds to an RF-coil or a respective individual portion of an RF-coil. By means of pTx, inhomogeneities in the excitation field, commonly denoted as B1, can be significantly reduced, in particular for ultrahigh field strengths, UHF, of the main magnetic field B0, for example for B0 $\geq$ 7 T. In pTx, the complex-valued relationship between the transmission channels varies spatially with static pTx-shimming, offering additional degrees of freedom to homogenize the B1 field.

One problem that can arise in SMS imaging and even more in applications, where SMS is combined with pTx, is that the overall amplitude of the transmitted excitation pulses may exceed predefined limits, for example limits due to technical limitations of the involved electronic devices and components and/or limits regarding the exposure of patients and staff to electromagnetic radiation.

The publication by E. Wong: "Optimized Phase Schedules for Minimizing Peak RF Power in Simultaneous Multi-Slice RF Excitation Pulses.", proceedings of the 20th Annual Meeting of the International Society of Magnetic Resonance Medicine, 20 (2012) it is shown that, by using an optimized set of excitation phases across slices, the peak power may be reduced.

For the combination of SMS and pTx, the described approach cannot be used in the same way as for single transmission MRI, since the phase difference between pTx channels varies along the slice dimension producing specific summation patterns for SMS.

In the publication F. Padormo et al.: "Parallel transmission for ultrahigh-field imaging", NMR in Biomedicine, 29, 1145-1161 (2016) it is discussed, how pTx can be used to achieve more uniform excitation field for ultrahigh-field MRI.

It is an objective of the present invention to provide a possibility to reduce the peak amplitude and/or peak power of excitation RF-pulses in SMS-pTx-MRI.

This objective is achieved by the subject-matter of the independent claim. Further implementations and preferred embodiments are subject-matter of the dependent claims.

The invention is based on the idea to construct a specific RF-waveform for each combination of a slice and a transmission channel and, for each transmission channel, generate a channel specific RF-waveform by summing up the individual RF-waveforms over all slices for the respective transmission channel. Optimal slice specific phases are determined by minimizing a cost function, which corresponds to a maximum of the respective absolute values of the channel-specific RF-waveforms.

According to an aspect of the invention, a computer-implemented method for determining channel-specific RF-waveforms for excitation RF-pulses for simultaneous multi-slice parallel transmission magnetic resonance imaging, SMS-pTx-MRI, is provided. Therein, for each combination of a slice of two or more slices and a transmission channel of two or more transmission channels, a respective combination-specific RF-waveform, which comprises a respective phase offset, is determined, in particular for a predefined time interval. Therein, the phase offset comprises a variable slice-specific phase, which depends on the respective slice and is the same for all transmission channels of the two or more transmission channels. For each transmission channel of the two or more transmission channels, a variable channel-specific RF-waveform is determined by summing up all of the combination-specific RF-waveforms of the combination-specific waveforms, which correspond to a combination of any slice of two or more slices with the respective transmission channel.

For each slice of the two or more slices, a final slice-specific phase is determined by minimizing a cost function using the variable slice-specific phases, in particular all of the variable slice-specific phases, as optimization variables. The cost function corresponds to a maximum of the respective absolute values of the variable channel-specific RF-waveforms, in particular all of the variable channel-specific RF-waveforms, within the predefined time interval. For each transmission channel of the two or more transmission channels, a final channel-specific RF-waveform is determined by replacing the variable slice-specific phases in the respective variable channel-specific RF-waveform by the final slice-specific phases.

Unless stated otherwise, all steps of the computer-implemented method may be performed by a data processing apparatus, which comprises at least one computing unit, in particular a data processing apparatus of an MRI-system. In particular, the at least one computing unit is configured or adapted to perform the steps of the computer-implemented method. For this purpose, the at least one computing unit may for example store a computer program comprising instructions which, when executed by the at least one computing unit, cause the at least one computing unit to execute the computer-implemented method.

The final channel-specific RF-waveforms can be understood as a result of the computer-implemented method. When using this result for SMS-pTx-MRI, respective excitation RF-pulses may be generated according to the final channel-specific RF-waveforms by controlling respective RF-coils of the MRI-system in order to excite nuclear spins of an object to be imaged accordingly.

A waveform can be understood as a wave in the predefined time interval, in particular in a complex notation. In other words, a waveform is generally given by A(t)*exp(i*Φ(t)) wherein A denotes the amplitude of the individual waveform, which may or may not depend on the time t, and Φ denotes the phase of the waveform, which depends on the time t.

It is noted that, in particular, the total number of slices according to the SMS imaging N as well as the total number of transmission channels according to the pTx imaging $N_C$ are predefined parameters, respectively. Each combination is characterized by one of the N slices and one of the Nc transmission channels. Consequently, there exist N x $N_C$ combinations of slices and transmission channels. For each of these combinations, the combination-specific RF-waveform is determined.

While the slice-specific phase is the same for all transmission channels, the phase offset may, in some implementations, comprise also a channel-specific phase, which is different for different transmission channels and, for example, may be the same for all slices. Furthermore, the combination-specific RF-waveforms may not only differ in their phases but, at least in some implementations, may differ also in their amplitudes. The respective amplitudes may be different for different transmission channels and the same for all slices or they may be different for different slices and the same for all transmission channels or they may be different for different slices and different for different transmission channels.

The amplitudes of the channel-specific RF-waveforms may also be considered as predefined parameters, which may, for example, be obtained in a known way by using a method for B1-shimming. This may involve further optimization steps. In the optimization for minimizing the cost function in the present computer-implemented method, however, the amplitudes are not used as variables for the optimization. In particular, only the variable slice-specific phases are used as optimization variables.

The variable slice-specific phases can be understood as variables as their values are not known per se prior to the optimization or minimization, respectively, of the cost function. In fact, the result of the optimization corresponds to the respective values of the slice-specific phases, which are then no longer denoted as variable slice-specific phases but final slice-specific phases.

By using the computer-implemented method, the additional degrees of freedom for selecting the slice-specific phases resulting from the combination of SMS with pTx are exploited to find an optimum solution, which minimizes the peak amplitudes and, consequently, RF-power of the excitation RF-pulses for SMS-pTx-MRI. Consequently, more stringent limits regarding peak amplitudes or RF-power for electronic components of the MR-system may be adhered to and/or the exposition to RF-fields of patients and/or staff may be reduced.

According to several implementations, a predefined reference RF-waveform is provided and, for each of the combinations, a respective RF-shimming coefficient is provided. For each of the combinations, the combination-specific RF-waveform is given by the reference RF-waveform multiplied with the respective RF-shimming coefficient and phase-shifted by the respective phase offset.

The reference RF-waveform is, in particular, the same for all combinations and has a predefined phase, which is also the same for all combinations. For phase shifting the RF-waveforms, the respective phase offset is therefore added to the phase of the reference RF-waveform.

The reference RF-waveform may also be denoted as a single-slice and single-channel waveform.

It is noted that, as mentioned above, the RF-shimming coefficients may be complex numbers, in general. Consequently, multiplying the reference RF-waveform with the respective RF-shimming coefficient may involve an additional phase-shift in addition to the phase-shift by the phase offset mentioned above.

The combination-specific RF-waveform for a slice k and a transmission channel j is the given by

$$RF_{j,k}(t) = w_{j,k}\, RF_0(t)\, exp(i\Delta(t)),$$

wherein $w_{j,k}$ denotes the respective RF-shimming coefficient, $RF_0$ denotes the reference RF-waveform and $\Delta$ denotes the phase offset. It is noted that $w_{j,k}$ depends on j and may depend on k but may also be independent of k.

According to several implementations, for each of the combinations, the respective phase offset comprises a further slice-specific phase, which depends on a spatial location of the respective slice and is the same for all transmission channels of the two or more transmission channels.

The further slice-specific phases are, however, not varied in the course of the minimization of the cost function.

For example, the further slice-specific phase may be time-dependent. Therefore, the phase-offset is also time-dependent in this case.

The spatial location of the respective slice corresponds to a coordinate in a corresponding reference coordinate system, along the predefined slice direction, which is, in particular, the same for all combinations. The slice direction is, in particular, given by the direction of a corresponding slice selection magnetic field gradient, which may be applied by means of one or more gradient coils of the MR-system.

According to several implementations, the further slice-specific phase is given by a product of a predefined slice-selection gradient amplitude, a gyromagnetic ratio of nuclear spins to be excited, the spatial location of the respective slice and the time.

In other words, the further slice-specific phase is given by

$$\gamma G x_k t \, ,$$

wherein $\gamma$ denotes the gyromagnetic ratio, G denotes the slice selection gradient amplitude, and $x_k$ denotes the spatial location of the k-th slice, wherein $1 \leq k \leq N$.

In particular, the phase offset is given by a sum of the slice-specific phase $\varphi_k$ and the further slice-specific phase.

According to several implementations, the cost function is given by

$$C = \max_{0 < t \leq T} \{ abs(RF_1(t)), \dots, abs(RF_{N_C}(t)) \} \, ,$$

wherein the predefined time interval is given by [0,T], t denotes the time, $RF_j$ denotes the variable channel-specific RF-waveform of the j-th transmission channel, wherein $1 \leq j \leq N_C$, and $N_C$ denotes the total number of the two or more transmission channels.

The function abs() corresponds to the absolute value of the corresponding variable channel-specific RF-waveform as a function of time and the function max{} selects the maximum value of all the absolute values within the predefined time interval. The optimization or minimization, respectively, is carried out by varying the variable slice-specific phases in order to find the minimum of the maximum of all the absolute values of the variable channel specific waveforms within the predefined time interval. In particular, the absolute value of a variable channel-specific RF-waveform can be understood as a pulse voltage of the respective variable channel-specific RF-waveform.

The minimization can be carried out according to various known methods including local optimizations to find a local minimum of the cost function or global optimizations to find a global minimum of the cost function. A global optimization can involve the repeated application of a local minimization with different starting conditions or a specific global optimization algorithm, such as, for example, simulating annealing.

In this way, the maximum peak amplitudes of the RF-waveforms finally used for the RF-excitation pulses may be particularly low.

According to several implementations, a Nelder-Mead optimization algorithm or an interior-point optimization algorithm or a simulated annealing optimization algorithm is used for minimizing the cost function.

In this way, a robust and reliable minimization may be achieved.

According to a further aspect of the invention, a method for SMS-pTx-MRI is provided. Therein, a computer-implemented method for determining channel-specific RF-waveforms for excitation RF-pulses for SMS-pTx-MRI according to the invention is carried out, in particular by at least one computing unit, for example of an MRI-system. Nuclear spins of an object to be imaged are excited by controlling two or more RF-coils, which correspond to the two or more transmission channels, of the MRI-system to emit excitation RF-pulses according to the final channel-specific RF-waveforms, in particular into the object.

It is noted that the expression "RF-coil" is used herein with the meaning that different RF-coils can correspond to independent RF-coils that are mechanically independent of each other and can be placed at different positions, for example, as well as different portions of a common RF-coil module, wherein each portion is electrically controllable independently from the other portions.

By generating the RF-excitation pulses according to the final channel-specific RF-waveforms, the peak amplitude and RF-power of the excitation RF-pulses are reduced as explained above.

Further implementations of the method for SMS-pTx-MRI according to the invention follow directly from the various embodiments of the computer-implemented **method** according to the invention and vice versa. In particular, individual features and corresponding explanations as well as advantages relating to the various implementations of the computer-implemented **method** according to the invention can be transferred analogously to corresponding implementations of the method for SMS-pTx-MRI according to the invention.

According to a further aspect of the invention, a data processing apparatus comprising at least one computing unit is provided. The at least one computing unit is adapted to carry out a computer-implemented method for determining channel-specific RF-waveforms for excitation RF-pulses for SMS-pTx-MRI according to the invention.

A computing unit may in particular be understood as a data processing device, which comprises processing circuitry. The computing unit can therefore in particular process data to perform computing operations. This may also include operations to perform indexed accesses to a data structure, for example a look-up table, LUT.

In particular, the computing unit may include one or more computers, one or more microcontrollers, and/or one or more integrated circuits, for example, one or more application-specific integrated circuits, ASIC, one or more field-programmable gate arrays, FPGA, and/or one or more systems on a chip, SoC. The computing unit may also include one or more processors, for example one or more microprocessors, one or more central processing units, CPU, one or more graphics processing units, GPU, and/or one or more signal processors, in particular one or more digital signal processors, DSP. The computing unit may also include a physical or a virtual cluster of computers or other of said units.

In various embodiments, the computing unit includes one or more hardware and/or software interfaces and/or one or more memory units.

A memory unit may be implemented as a volatile data memory, for example a dynamic random access memory, DRAM, or a static random access memory, SRAM, or as a non-volatile data memory, for example a read-only memory, ROM, a programmable read-only memory, PROM, an erasable programmable read-only memory, EPROM, an electrically erasable programmable read-only memory, EEPROM, a flash memory or flash EEPROM, a ferroelectric random access memory, FRAM, a magnetoresistive random access memory, MRAM, or a phase-change random access memory, PCRAM.

According to a further aspect of the invention, a magnetic resonance imaging system, MRI-system, is provided. The MRI-system comprises a data processing apparatus according to the invention, a magnet unit with an imaging region for placing an object to be imaged into the imaging region, and two or more RF-coils, which correspond to the two or more transmission channels. The at least one computing unit is configured to control the two or more RF-coils to emit excitation RF-pulses according to the final channel-specific RF-waveforms into the imaging region.

Furthermore, the MRI-system may comprise all components which are required to carry out MRI, in particular SMS-pTx-MRI. These components are known and can be implemented in a conventional manner. Such components include, for example, a field magnet for generating the main magnet field, one or more gradient coils for applying magnet field gradients, RF-detection coils for detecting MR-signals emitted by the object to be imaged in response to the excitation RF-pulses, RF-generators, and so forth. It is noted that, in some implementations, the two or more RF-coils or some of the two or more RF-coils may also be used as detection RF-coils. Alternatively or in addition, local detection coils or further specific detection coils may be used.

Further implementations of the MRI-system according to the invention follow directly from the various embodiments of the computer-implemented method and the method for SMS-pTx-MRI according to the invention and vice versa. In particular, individual features and corresponding explanations as well as advantages relating to the various implementations of the computer-implemented method and the method for SMS-pTx-MRI according to the invention can be transferred analogously to corresponding implementations of the MRI-system according to the invention. In particular, the MRI-system according to the invention is designed or programmed to carry out the method for SMS-pTx-MRI according to the invention. In particular, the MRI-system according to the invention carries out the method for SMS-pTx-MRI according to the invention.

According to a further aspect of the invention, a first computer program comprising first instructions is provided. When the first instructions are executed by a data processing apparatus, in particular by a data processing apparatus according to the invention, the first instructions cause the data processing apparatus to carry out a computer-implemented method for determining channel-specific RF-waveforms for excitation RF-pulses for SMS-pTx-MRI according to the invention.

The first instructions may be provided as program code, for example. The program code can for example be provided as binary code or assembler and/or as source code of a programming language, for example C, and/or as program script, for example Python.

According to a further aspect of the invention, a second computer-program product comprising second instructions is provided. When the second instructions are executed by an MRI-system according to the invention, in particular by the data processing apparatus of the MRI-system, the second instructions cause the MRI-system to carry out a method for SMS-pTx-MRI according to the invention.

The second instructions may be provided as program code, for example. The program code can for example be provided as binary code or assembler and/or as source code of a programming language, for example C, and/or as program script, for example Python.

According to a further aspect of the invention, a computer-readable storage medium storing a first computer program and/or a second computer program according to the invention is provided.

The first computer program, the second computer program as well as the computer-readable storage medium according to the invention may be denoted as respective computer program products comprising the first instructions and/or the second instructions.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, may also be comprised by the invention. Moreover, embodiments and combinations of features, which go beyond or deviate from the combinations of features set forth in the recitations of the claims may be comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures,

FIG 1    shows a schematic block diagram of an exemplary implementation of an MRI-system according to the invention;

FIG 2    shows schematically exemplary waveforms; and

FIG 3    shows a schematic flow diagram of an exemplary implementation of a computer-implemented method for determining channel-specific RF-waveforms for excitation RF-pulses for SMS-pTx-MRI according to the invention.

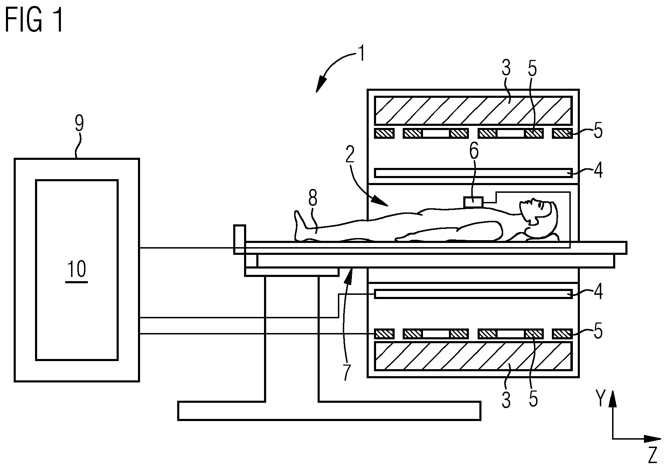

FIG 1 shows a schematic representation of an exemplary implementation of an MRI-system 1 according to the invention.

The MRI-system comprises a magnet unit with an imaging region 2, for example within a patient tunnel for placing an object 8, in particular a patient, to be imaged. The magnet unit comprises a field magnet 3 that generates a main magnet field for aligning nuclear spins of the object, in particular within the imaging region 2. The imaging region 2 is characterized by a very homogeneous static main magnet field, the homogeneity relating, in particular, to the magnetic field strength. The field magnet 3 may, for example, be a superconducting magnet capable of providing magnetic fields with a magnetic flux density in the order of several Tesla, in particular in the order of 7 T or more. A patient table 7 may be movable within the patient tunnel.

Furthermore, the magnet unit comprises a gradient coil arrangement 5 with several gradient coils that are designed to superimpose location-dependent magnetic fields in the three spatial directions on the static main magnet field for spatial differentiation and, in particular, slice selection. The gradient coils of the gradient coil arrangement 5 may, for example, be designed as coils of normal conducting wires, which may, for example, generate mutually orthogonal fields or field gradients in the recording region.

The MRI-system 1, in particular the magnet unit, comprises a transmission coil arrangement, which contains two or more RF-coils 4. It is noted that the two or more RF-coils 4 of the transmission coil arrangement may, depending on the specific implementation or application, also be used as receiving coils. Optionally, the MRI-system 1 may also comprise one or more local coils 6, which may be arranged in the immediate vicinity of the object 8, for example on the object 8 or in the patient table 7. The local coils 6 may serve as receiving coils and/or transmission coils.

The MRI-system 1 is adapted to perform SMS-pTx-MRI, wherein each of the two or more RF-coils 4 and, in some implementations, the local coil 6, correspond to one of two or more transmission channels.

The MRI-system 1 also comprises a data processing apparatus 9 including at least one computing unit 10. The at least one computing unit 10 is configured to carry out a computer-implemented method for determining channel-specific RF-waveforms for excitation RF-pulses for SMS-pTx-MRI. As a result of the computer-implemented method, the at least one computing unit 10 determines for each transmission channel of the two or more transmission channels a final channel-specific RF-waveform.

The at least one computing unit 10 controls the two or more RF-coils 4 and, for example, the local coil 6, to emit respective excitation RF-pulses according to the final channel-specific RF-waveforms into the imaging region 2. Therein, each of the two or more RF-coils 4 and/or local coil 6, it is controlled to emit a corresponding RF-pulse according to one of the channel-specific RF-waveform, which corresponds to the transmission channel of the respective RF-coil 4, 6.

In response to the excitation RF-pulses, the at least one computing unit 10 receives corresponding NMR-signals from the receiving coils and may generate respective MR-images of the object 8 depending on those signals.

In particular, the at least one computing unit may comprise a readout control unit, which is connected to the at least one RF-coils 4 and/or the local coil 6. Depending on the detected MR-signals, the readout control unit, which may comprise an analogue-to-digital converter, ADC, may generate corresponding MR-data, in particular in k-space.

The at least one computing unit 10 may evaluate the MR-data and, for example, carry out a two-dimensional or three-dimensional image reconstruction based on the MR-data. The at least one computing unit 10 also comprises a sending control unit, which is connected to and controls the two or more RF-coils 4 and/or the local coil 6 to emit the excitation RF-pulses and, for example refocusing RF-pulses and other RF-pulses. The at least one computing unit 10 comprises gradient control unit, which is connected to and controls the gradient coil arrangement 5 to apply, for example, slice selecting gradients, gradients for frequency and/or phase encoding, defocusing gradients and/or readout gradients and so forth.

It is noted that the described structure of the MRI-system 1 is a non-limiting example only. The different required tasks and functions may also be distributed differently and/or to different units in other applications.

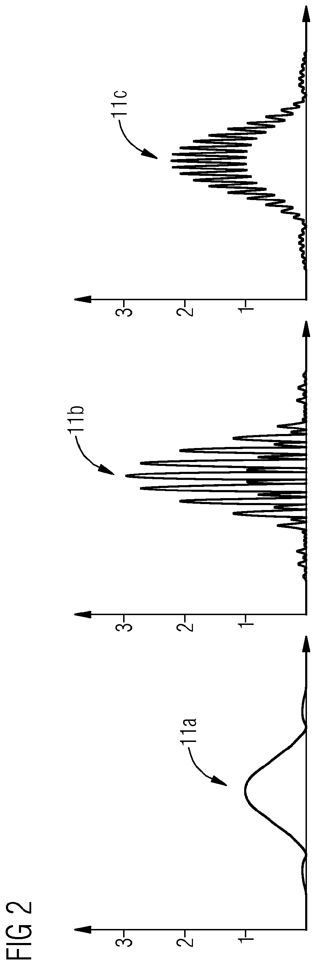

When performing SMS-pTx-MRI, the individual RF-pulses may interfere constructively, and therefore relatively large peak amplitudes may result depending on the mutual phase differences between the RF-pulses. As an example, three different waveforms 11a, 11b, 11c are shown in FIG 2. It is noted that the waveforms 11a, 11b, 11c correspond to single transmission, sTx, MRI. The waveform 11a corresponds to a single-slice sTx waveform, and the waveform 11b corresponds to a three-slice sTx waveform with non-optimized phase differences between the individual slices. The waveform 11c corresponds to a three-slice sTx waveform with optimized phases. In particular, the waveform 11c may be achieved for a specific transmission channel by the computer-implemented method according to the invention. In implementations of the computer-implemented method, a corresponding waveform 11c would be received for each transmission channel. As can be seen in FIG 2, the optimized waveform has a significantly lower peak amplitude compared to the non-optimized waveform 11b.

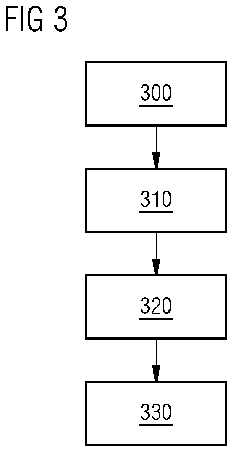

FIG 3 shows a schematic flow diagram of an exemplary implementation of a computer-implemented method for determining channel-specific RF-waveforms for excitation RF-pulses for SMS-pTx-MRI according to the invention, as may be carried out, for example, by the at least one computing unit 10 to determine the waveforms of the RF-excitation pulses as described with respect to FIG 1.

In step 300, for each combination of a slice of the two or more slices and a transmission channel of the two or more transmission channels, a respective combination-specific RF-waveform, which comprises a respective phase offset, the phase offset comprising a variable slice specific phase, which depends on the respective slice and is the same for all transmission channels, is determined by the at least one computing unit 10. For example, a predefined RF-waveform and a set of RF-shimming coefficients for each of the combinations is provided and the combination-specific RF-waveform is determined as the reference RF-waveform multiplied with the respective RF-shimming coefficient and phase-shifted by the respective phase offset. In particular, the phase offset may comprise a further slice-specific phase, which depends on the spatial location of the respective slice and is the same for all transmission channels. As a result, in such implementations, the combination-specific RF-waveform for a slice k and a transmission channel j may be given by

$$RF_{j,k}(t) = w_{j,k} \, RF_0(t) \, exp(i\gamma G x_k t + i\varphi_k),$$

wherein $\gamma$ denotes the gyromagnetic ratio, G denotes the slice selection gradient amplitude, and $x_k$ denotes the spatial location of the k-th slice, $\varphi_k$ denotes the slice-specific

phase, $w_{j,k}$ denotes the RF-shimming coefficient and $RF_0$ denotes the reference RF-waveform.

In step 310, for each transmission channel of the two or more transmission channels is determined by summing up all of the combination-specific RF-waveforms, which correspond to the respective transmission channel. The variable channel-specific RF-waveform is given by

$$RF_j(t) = \sum_{k=1}^{N} RF_{j,k}(t).$$

In step 320, for each slice of the two or more slices, a final slice-specific phase is determined by minimizing a cost function using the variable slice-specific phases as optimization variables, wherein the cost function corresponds to a maximum of the respective absolute values of the variable channel-specific RF-waveforms within a predefined time interval. In particular, the cost function is given by

$$C = \max_{0 < t \leq T} \{abs(RF_1(t)), \dots, abs(RF_{N_C}(t))\},$$

wherein the predefined time interval is given by [0,T], t denotes the time, $RF_j$ denotes the variable channel-specific RF-waveform of the j-th transmission channel, wherein $1 \leq j \leq N_C$, and $N_C$ denotes the total number of the two or more transmission channels.

In step 330, for each transmission channel of the two or more transmission channels, a final channel-specific RF-waveform is determined by replacing the variable slice-specific phases in the respective variable channel-specific RF-waveform by the final slice-specific phases obtained in step 320 by the minimization.

The minimization can be achieved by a variety of algorithms, including, but not limited to, the Nelder-Mead algorithm, interior-point algorithm and simulated annealing. It is also possible to run a local solver, for example, interior point algorithm from multiple starting points to find a global minimum.

As described, in particular with respect to the figures, the invention allows to reduce the peak amplitude and RF-power of RF-excitation pulses in SMS-pTx-MRI.

Using a factorial study design, the computer-implemented method according to the invention has been evaluated against the sTx phase scheduling of the publication of E. Wong. The optimal slice specific phases have been calculated for a Hanning-filtered sinc pulse using four optimization methods including Nelder-Mead, interior point, simulated annealing and global search for different numbers of slices between three and six. It has been found that all four optimization methods yielded significant reductions in the peak amplitudes by 15 to 40%.

The invention may be applied to all MR-sequences with SMS and pTx, including slice-by-slice shimming or spokes, in order to significantly reduce the peak RF-amplitudes and peak power.

Independent of the grammatical term usage, individuals with male, female or other gender identities are included within the term.

**Claims**

1. Computer-implemented method for determining channel-specific RF-waveforms for excitation RF-pulses for simultaneous multi-slice parallel transmission magnetic resonance imaging, SMS-pTx-MRI, wherein

   - for each combination of a slice of two or more slices and a transmission channel of two or more transmission channels, a respective combination-specific RF-waveform, which comprises a respective phase offset, the phase offset comprising a variable slice-specific phase, which depends on the respective slice and is the same for all transmission channels, is determined;
   - for each transmission channel of the two or more transmission channels, a variable channel-specific RF-waveform is determined by summing up all of the combination-specific RF-waveforms, which correspond to the respective transmission channel;
   - for each slice of the two or more slices, a final slice-specific phase is determined by minimizing a cost function using the variable slice-specific phases as optimization variables, wherein the cost function corresponds to a maximum of the respective absolute values of the variable channel-specific RF-waveforms within a predefined time interval;
   - for each transmission channel of the two or more transmission channels, a final channel-specific RF-waveform is determined by replacing the variable slice-specific phases in the respective variable channel-specific RF-waveform by the final slice-specific phases.

2. Computer-implemented method according to claim 1, wherein

   - a predefined reference RF-waveform is provided and, for each of the combinations a respective RF-shimming coefficient is provided; and
   - for each of the combinations, the combination-specific RF-waveform is given by the reference RF-waveform multiplied with the respective RF-shimming coefficient and phase-shifted by the respective phase offset.

3. Computer-implemented method according to one of the preceding claims, wherein, for each of the combinations, the respective phase offset comprises a further slice-specific phase, which depends on a spatial location of the respective slice and is the same for all transmission channels.

4. Computer-implemented method according to claim 3, wherein the further slice-specific phase is given by a product of a predefined slice-selection gradient amplitude, a gyromagnetic ratio, the spatial location of the respective slice and time.

5. Computer-implemented method according to one of the preceding claims, wherein the cost function is given by

$$C = \max_{0 < t \leq T}\left\{abs(RF_1(t)), \ldots, abs\left(RF_{N_C}(t)\right)\right\},$$

wherein the predefined time interval is given by [0,T], t denotes the time, $RF_j$ denotes the variable channel-specific RF-waveform of the j-th transmission channel, wherein $1 \leq j \leq N_C$ and $N_C$ denotes the total number of the two or more transmission channels.

6. Computer-implemented method according to one of the preceding claims, wherein a Nelder-Mead optimization algorithm or an interior-point optimization algorithm or a simulated annealing optimization algorithm is used for minimizing the cost function.

7. Method for SMS-pTx-MRI, wherein

- a computer-implemented method according to one of the preceding claims is carried out;
- nuclear spins of an object (8) to be imaged are excited by controlling two or more RF-coils (4, 6), which correspond to the two or more transmission channels, of an MRI-system (1) to emit excitation RF-pulses according to the final channel-specific RF-waveforms.

8. Data processing apparatus (9) comprising at least one computing unit (10), which is adapted to carry out a computer-implemented method according to one of claims 1 to 6.

9. Magnetic resonance imaging system, MRI-system, (1) comprising a data processing apparatus (9) according to claim 8, a magnet unit with an imaging region (2) for placing an object (8) to be imaged, and two or more RF-coils (4, 6), which correspond to the two or more transmission channels, wherein the at least one computing unit (10) is configured to control the two or more RF-coils (4, 6) to emit excitation RF-pulses according to the final channel-specific RF-waveforms into the imaging region (2).

10. Computer program product comprising instructions, which, when executed by a data processing apparatus (9), cause the data processing apparatus (9) to carry out a computer-implemented method according to one of claims 1 to 6.

11. Computer-program product comprising instructions, which, when executed by an MRI-system (1) according to claim 9, cause the MRI-system (1) to carry out a method according to claim 7.

FIG 1

FIG 2

FIG 3

```
┌─────────┐
│   300   │
└─────────┘
     │
     ▼
┌─────────┐
│   310   │
└─────────┘
     │
     ▼
┌─────────┐
│   320   │
└─────────┘
     │
     ▼
┌─────────┐
│   330   │
└─────────┘
```

Europäisches
Patentamt

European
Patent Office

Office européen
des brevets

# EUROPEAN SEARCH REPORT

Application Number

EP 23 17 3689

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SBRIZZI ALESSANDRO ET AL: "RF peak power reduction in CAIPIRINHA excitation by interslice phase optimization", NMR IN BIOMEDICINE., vol. 28, no. 11, 21 September 2015 (2015-09-21), pages 1393-1401, XP093092655, GB ISSN: 0952-3480, DOI: 10.1002/nbm.3360 * page 1394 - page 1399 * | 1-11 | INV. G01R33/483 G01R33/561 |
| A | BENEDIKT A. POSER ET AL: "Simultaneous multislice excitation by parallel transmission : Simultaneous Multislice pTX Excitation", MAGNETIC RESONANCE IN MEDICINE, vol. 71, no. 4, 28 May 2013 (2013-05-28), pages 1416-1427, XP055742829, US ISSN: 0740-3194, DOI: 10.1002/mrm.24791 * the whole document * | 1-11 | |

TECHNICAL FIELDS
SEARCHED (IPC)

G01R

The present search report has been drawn up for all claims

| Place of search | Date of completion of the search | Examiner |
|---|---|---|
| Munich | 31 October 2023 | Raguin, Guy |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
...........................................................................
& : member of the same patent family, corresponding
document

EPO FORM 1503 03.82 (P04C01)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **E. WONG.** Optimized Phase Schedules for Minimizing Peak RF Power in Simultaneous Multi-Slice RF Excitation Pulses. *proceedings of the 20th Annual Meeting of the International Society of Magnetic Resonance Medicine,* 2012, vol. 20

- **F. PADORMO et al.** Parallel transmission for ultrahigh-field imaging. *NMR in Biomedicine,* 2016, vol. 29, 1145-1161